## Europäisches Patentamt

## European Patent Office

## Office européen des brevets

(19)

(11) Numéro de publication: **0 153 251**
**B1**

(12) **FASCICULE DE BREVET EUROPÉEN**

(45) Date de publication du fascicule du brevet:
29.03.89

(51) Int. Cl.⁴: **H 01 L 27/14**

(21) Numéro de dépôt: **85400279.7**

(22) Date de dépôt: **15.02.85**

(54) Capteur d'images à barettes multilinéaires à transfert de charges.

(30) Priorité: **21.02.84 FR 8402573**

(43) Date de publication de la demande:
**28.08.85 Bulletin 85/35**

(45) Mention de la délivrance du brevet:
**29.03.89 Bulletin 89/13**

(84) Etats contractants désignés:
**DE GB NL**

(56) Documents cité:
**EP-A-0 038 725**
**US-A-4 349 743**

**IEEE TRANSACTIONS ON ELECTRON DEVICES,
vol. ED-27, no. 1, janvier 1980, pages 175-188, IEEE,
New York, US; P. FELIX et al.: "CCD readout of
infrared hybrid focal-plane arrays"
C.H.Séquin, M.F.Tompett: "Charge Transfer
Devices", Academic Press, New York 1975, p.195-
200 et 207-209**

(73) Titulaire: **THOMSON- CSF, 173, Boulevard
Haussmann, F-75379 Paris Cédex 08 (FR)**

(72) Inventeur: **Berger, Jean- Luc, THOMSON- CSF
SCPI 173, bld Haussmann, F-75379 Paris Cedex 08
(FR)**
Inventeur: **Coutures, Jean- Louis, THOMSON- CSF
SCPI 173, bld Haussmann, F-75379 Paris Cedex 08
(FR)**
Inventeur: **Descure, Pierrick, THOMSON- CSF
SCPI 173, bld Haussmann, F-75379 Paris Cedex 08
(FR)**
Inventeur: **Moiroud, Guy, THOMSON- CSF SCPI
173, bld Haussmann, F-75379 Paris Cedex 08 (FR)**

(74) Mandataire: **Ruellan- Lemonnier, Brigitte,
THOMSON- CSF SCPI 19, avenue de Messine,
F-75008 Paris (FR)**

LIBER, STOCKHOLM 1989

## Description

La présente invention concerne les barrettes multilinéaires à transfert de charge. Elle concerne, plus particulièrement les barrettes multilinéaires à transfert de charge adaptées à l'association de plusieurs barrettes élémentaires et fonctionnant selon le principe de l'intégration avec report des charges connu dans la littérature anglo-saxonne sous le nom de "Time Delay Integration" ou TDI.

Des barrettes multilinéaires actuellement connues sont constituées par N lignes de P détecteurs photosensibles tels que des photodiodes, chaque ligne recevant successivement le rayonnement à détecter et par des dispositifs permettant de sommer en synchronisme avec le défilement les informations recueillies sur les détecteurs de même rang, l'ensemble étant intégré sur un même substrat. Dans ce cas, le temps d'intégration est multiplié par N. Or le temps d'intégration étant multiplié par N et les bruits de lecture s'ajoutant de façon quadratique, on obtient un gain sur le rapport signal sur bruit égal à √N. Cet avantage est particulièrement intéressant, lorsque ces barrettes sont utilisées pour capter des images radiologiques, car l'augmentation du rapport signal sur bruit permet de diminuer la dose de rayons utilisée, pour un même temps d'exposition. De même, ce type de barrettes peut être utilisé pour détecter d'autres rayonnements en particulier, lorsque l'on souhaite détecter un rayonnement de faible niveau.

Toutefois, le fait d'intégrer la fonction TDI directement sur la barrette multilinéaire présente un certain nombre d'inconvénients.

L'intégration des détecteurs et des dispositifs réalisant la fonction TDI nécessite des substrats de dimensions relativement importantes et reste d'un coût de fabrication élevé. D'autre part, le sens de balayage est imposé. De plus, au niveau du fonctionnement on rencontre des problèmes de génération thermique de charges, d'où la nécessité de faire fonctionner la barrette multilinéaire à des fréquences élevées et à des températures relativement basses.

D'autre part, il est fréquent lorsque l'on souhaite pouvoir enregistrer des images de grandes dimensions, d'associer plusieurs barrettes multilinéaires de façon à former une barrette photosensible de grandes dimensions. Dans ce cas, toutefois, on observe une perte de résolution et de sensibilité au niveau de la transition d'une barrette à l'autre, pertes qui sont dues à l'absence d'un ou de plusieurs détecteurs photosensibles aux extrémités de chaque ligne des barrettes élémentaires. Une solution à ce problème est de disposer l'alignement des zones perturbées se trouvant aux extrémités de chacune des lignes dans une direction différente de celle du balayage. Toutefois, il n'est pas possible de réaliser un tel balayage lorsque les dispositifs TDI sont intégrés avec le dispositif photosensible, car le cumul devant être fait sur des détecteurs photosensibles alignés avec la direction du balayage, il est alors nécessaire de cumuler des informations situées sur deux barrettes élémentaires différentes.

Le capteur d'images de la présente invention tel que défini dans les revendications permet de remédier à cet inconvénient, des informations issues de deux barrettes différentes pouvant être cumulées sans problème. En conséquence, la présente invention a pour objet, un capteur d'images utilisant au moins deux barrettes multilinéaires dans lesquelles les détecteurs photosensibles sont lus individuellement et dans lesquelles la fonction TDI, ou éventuellement d'autres fonctions sont réalisées en dehors du substrat contenant la zone photosensible. Ce report à l'extérieur du substrat est décrit dans un article paru dans IEEE Transactions on Electron Devices, vol. ED-27, n° 1, janvier 1980, p. 175 - 188 intitulé "CCD readout of infrared hybrid focal plane arrays": il est prévu de reporter la fonction de report de charges et intégration à l'extérieur pour des considérations d'amélioration de dynamique ou de rapport signal/bruit. Ledit article se réfère à une seule barrette multilinéaire.

Suivant l'invention, le balayage et/ou la structure de la barrette sont telles que l'association de plusieurs barrettes pour former une barrette photosensible de grandes dimensions est possible et minimise les défauts d'images dûs au(x) raccordement(s).

D'autres caractéristiques et avantages de la présente invention apparaîtront à la lecture de la description de divers modes de réalisation donnés à titre d'exemple, la description étant faite avec référence aux dessins ci-annexés dans lesquels:

- la figure 1 est une vue schématique d'une barrette multilinéaire à lecture individuelle des détecteurs;
- la figure 2 est une vue schématique d'un deuxième mode de réalisation d'une barrette multilinéaire à lecture individuelle des détecteurs;
- la figure 3 est une vue schématique agrandie du système de multiplexage et de lecture intégré à la barrette de la figure 2;
- la figure 4 est une vue de dessus de la partie représentée schématiquement sur la figure 3;
- les figures 5a à 5d sont respectivement une vue en coupe par V-V de figure 4 et des représentations des potentiels de surface correspondants dans le substrat sur lequel est intégrée la barrette multilinéaire;
- les figures 6a et 6b, 7a et 7b, 8a et 8b sont respectivement une vue en coupe identique à celle de la figure 5a d'autres modes de réalisation d'un dispositif anti-éblouissement et une représentation des potentiels de surface correspondants dans le substrat;
- la figure 9 est une vue schématique semblable à celle de la figure 3 d'un deuxième mode de réalisation du système de multiplexage et lecture;

- les figures 10a et 10b sont respectivement une vue en coupe par VI-VI de figure 9 et une représentation des potentiels de surface correspondants;

- la figure 11 est une vue semblable à celle de figure 9 d'un troisième mode de réalisation du système de multiplexage et de lecture;

- les figures 12 à 15 représentent différents modes de réalisation d'une barrette multilinéaire élémentaire pour former une barrette de grandes dimensions selon l'invention;

- la figure 16 est un schéma d'un dispositif de traitement des signaux en sortie de la barrette multilinéaire.

Sur les différentes figures, les mêmes références désignent les mêmes éléments, mais pour des raisons de clarté, les cotes et proportions des divers éléments ne sont pas respectées.

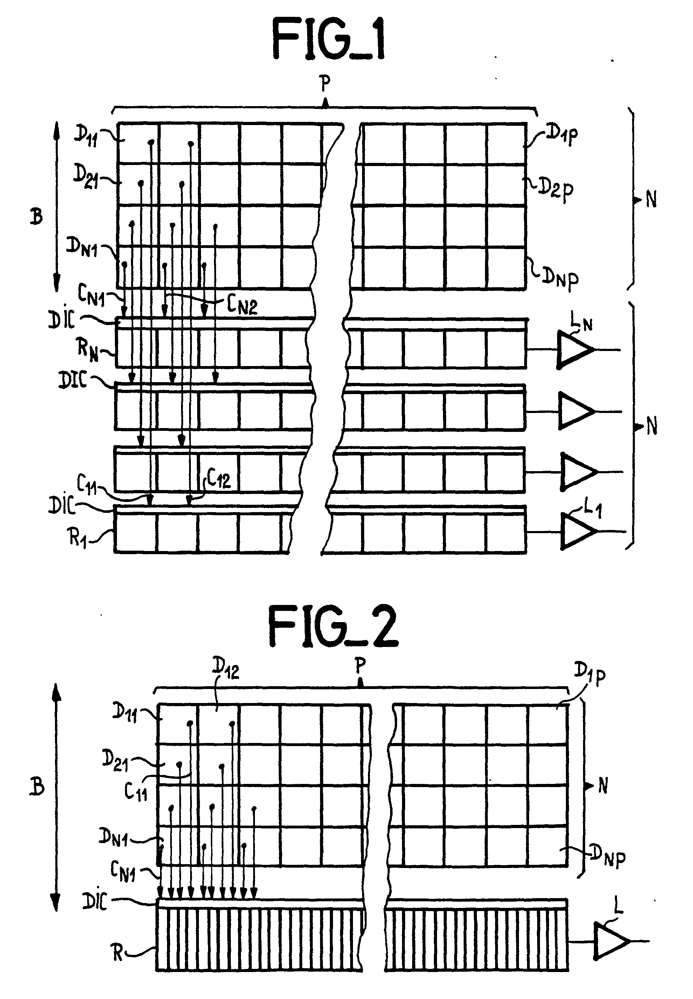

La barrette multilinéaire à transfert de charge représentée sur la figure 1 est une barrette multilinéaire dans laquelle le dispositif de traitement des informations reçues n'est pas intégré sur le même substrat que la zone photosensible.

Comme représenté sur la figure 1, la barrette est constituée principalement par une zone photosensible comportant N lignes de P détecteurs $D_{11}$, $D_{12}$,...$D_{1P}$,...$D_{N1}$,...$D_{NP}$, et par un système de multiplexage et de lecture de charges. Les détecteurs photosensibles $D_{11}$ à $D_{NP}$ sont constitués par exemple par des photodiodes. D'autre part, dans le mode de réalisation représenté à la figure 1, le système de multiplexage et de lecture de charges est constitué principalement par N registres à décalage à transfert de charge à entrées parallèles et sortie série dont chaque entrée est reliée par l'intermédiaire d'un dispositif d'injection des charges DIC et d'une connexion $C_{N1}$, $C_{N2}$,...$C_{11}$, $C_{12}$ à un des détecteurs correspondants $D_{11}$ à $D_{NP}$ et dont la sortie est connectée à un étage de lecture.

De manière plus détaillée, chaque ligne de détecteurs photosensibles est connectée à un registre à décalage à transfert de charge par l'intermédiaire d'une connexion et d'un dispositif d'injection des charges. Ainsi, la Nième ligne de détecteurs photosensibles $D_{N1}$ à $D_{NP}$ est connectée aux entrées du registre à décalage $R_N$, et la première ligne de détecteurs $D_{11}$ à $D_{1P}$ est connectée au registre à décalage $R_1$. Les signaux qui seront envoyés vers le dispositif de traitement externe sont obtenus séquentiellement en sortie des étages de lecture $L_1$ à $L_N$. Lorsque la barrette multilinéaire est utilisée, par exemple, pour capter des images radiologiques, la barrette défile selon le sens B devant l'objet ou le corps qui émet le rayonnement à détecter. Dans ce cas, le dispositif de traitement est un dispositif de sommation en synchronisme avec le défilement des informations recueillies sur les détecteurs de même rang, à savoir, par exemple, sur les détecteurs $D_{11}$, $D_{21}$, ... $D_{N1}$.

Selon un autre mode de réalisation d'une barrette à lecture individuelle des détecteurs au lieu d'utiliser N registres à décalage à transfert de charge associés avec des dispositifs d'injection de charge, il est possible d'utiliser un seul registre à décalage à transfert de charge comportant N x P étages comme représenté sur la figure 2.

En fait, le choix du nombre des registres à décalage à transfert de charge peut être fait en fonction de la définition géométrique des détecteurs photosensibles et desdits registres à décalage, en fonction du nombre de lignes photosensibles et des conditions retenues pour la mise en oeuvre et le traitement des signaux. Si l'on considère, par exemple, les facteurs géométriques, le nombre des registres à décalage à transfert de charge peut être donné par l'équation suivante:

$n_0$ = N x pas minimum des registres/pas des détecteurs dans laquelle: $n_0$ égale le nombre de registres et N égale le nombre de lignes photosensibles. $n_0$ est en fait un entier compris entre 1 et N, ces deux valeurs extrêmes étant représentées respectivement sur la figure 2 et sur la figure 1. Dans le cas de $n_0$ registres, le nombre d'étages $p_0$ de chaque registre est choisi pour que $p_0$ x $n_0$ = N x P.

La zone photosensible de la barrette multilinéaire de la figure 2 est identique à la zone photosensible de la barrette multilinéaire de la figure 1 déjà décrite. Comme mentionné ci-dessus, le registre R à décalage à transfert de charge utilisé comme multiplexeur dans le système de multiplexage et de lecture des charges de la barrette multilinéaire de la figure 2 est un registre à entrées parallèles et sortie série comportant N x P étages. Chaque entrée est reliée par l'intermédiaire d'un dispositif d'injection des charges DIC et d'une connexion $C_{np}$ (avec 1 ⩽ n ⩽ N et 1 ⩽ p ⩽ P) à un détecteur photosensible $D_{np}$ de la zone photosensible. Dans ce cas, les connexions sont effectuées de la manière suivante:

les premiers détecteurs photosensibles $D_{N1}$ à $D_{11}$ des N lignes sont connectés aux N premiers étages du registre R en commencant par la diode de la ligne N, et ainsi de suite pour les autres colonnes.

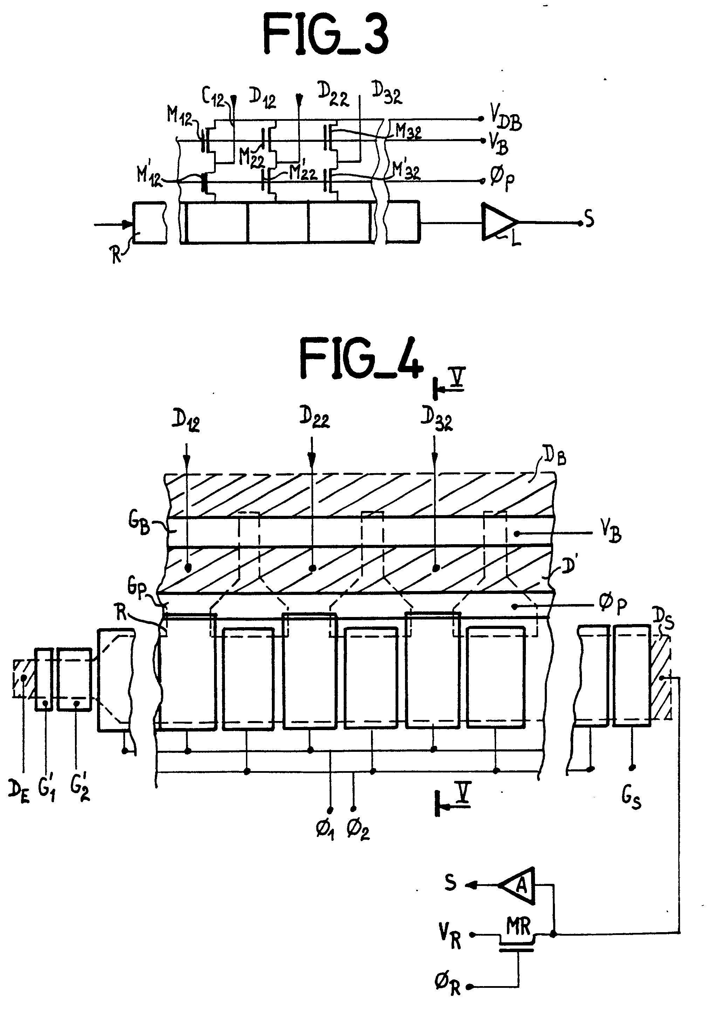

On décrira maintenant avec référence aux figures 3 à 5, la structure et le fonctionnement du système de multiplexage et de lecture des charges de la barrette multilinéaire de la figure 2.

Comme représenté sur les figures 3 et 4, chaque détecteur photosensible $D_{12}$, $D_{22}$, $D_{32}$, est connecté par l'intermédiaire d'une connexion $C_{12}$, $C_{22}$, $C_{32}$, ... à un dispositif d'injection de charge DIC constitué par une diode D' et par une grille $G_P$ reliée à un potentiel $\emptyset_P$ qui contrôle le passage des charges de la diode D' vers l'entrée d'un étage correspondant du registre à décalage R. Le DIC est en fait constitué par un transistor MOS $M'_{12}$, $M'_{22}$, $M'_{32}$ dont le drain est réalisé par la diode D', la grille par $G_P$ et la source induite par l'étage d'entrée du registre R.

Dans le mode de réalisation de la figure 4, on utilise un registre à décalage à transfert de charge dont chaque étage est constitué par un couple d'électrodes relié à un signal de commande $Ø_1$ et par un couple d'électrodes relié à un signal de commande $Ø_2$. Chaque couple d'électrodes est constitué par une électrode de stockage et une électrode de transfert. La dissymétrie dans les potentiels de surface nécessaire pour rendre le transfert unilatéral est réalisée, par exemple, par une surépaisseur d'oxyde ou par une implantation d'impuretés de même type que le substrat. D'autres types de registres à décalage à transfert de charge peuvent être utilisés.

De plus, le registre à décalage R comporte un dispositif d'injection de charge en série constitué par une diode $D_e$ et des grilles $G'_1$ et $G'_2$. Ce dispositif d'injection de charge permet d'injecter une charge $Q_O$ constituant un fond de charge dont le rôle sera expliqué en détail ci-après.

D'autre part, le registre à décalage R réalise le multiplexage des charges intégrées dans les détecteurs de la zone photosensible de la barrette multilinéaire et les transfèrent séquentiellement vers un étage de lecture charge-tension de type connu constitué par exemple par une grille $G_S$ et une diode $D_S$ reliée à la source d'un transistor MOS MR et à l'entrée d'un amplificateur A donnant en sortie le signal S. Le drain du transistor MOS est relié à une tension constante $V_R$ et sa grille à un potentiel $Ø_R$.

D'autre part, comme représenté sur les figures 3 et 4, la barrette multilinéaire comporte de plus un dispositif antiéblouissement constitué par des transistors MOS $M_{12}$, $M_{22}$, $M_{32}$ dont le drain $D_B$ est porté à un potentiel de polarisation $V_{DB}$, la grille $G_B$ est portée à une tension fixe $V_B$ et la source est constituée par la diode D' d'injection des charges à partir des détecteurs.

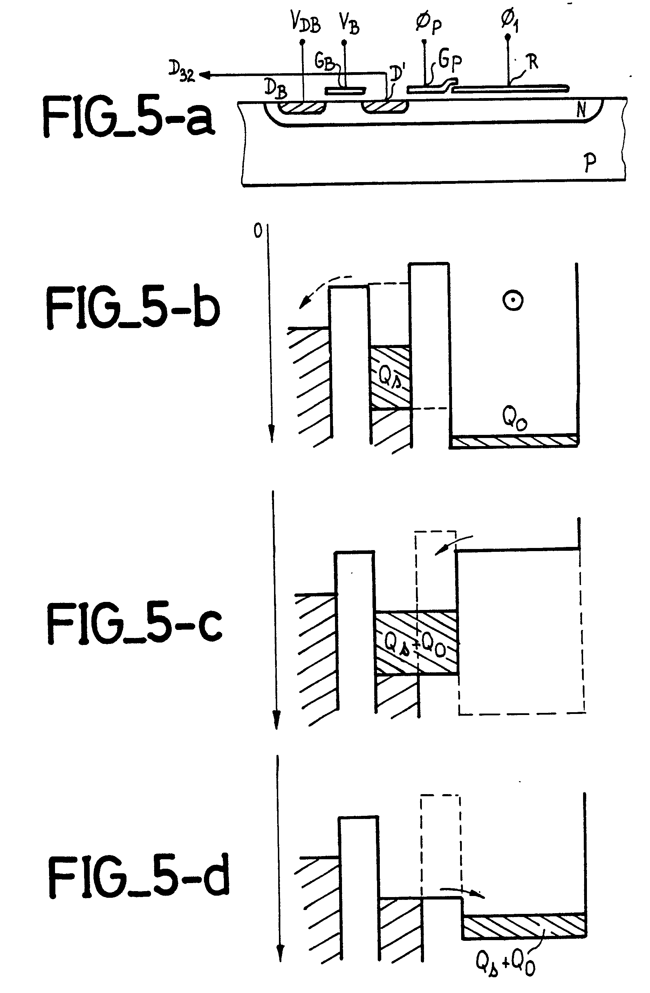

On expliquera maintenant avec référence aux figures 5a à 5d le fonctionnement d'un étage du système de multiplexage et de lecture décrit ci-dessus: Comme représenté sur la figure 5a, la barrette multilinéaire est réalisée sur un substrat en silicium de type P. Toutefois il est évident pour l'homme de l'art que des substrats semiconducteurs équivalents tels que des substrats en arséniure de gallium ou en silicium de type N peuvent aussi être utilisés. Le système de multiplexage et de lecture constitué par le dispositif d'injection de charge, le dispositif anti-éblouissement et le registre R est réalisé sur une diffusion de type N de manière à effectuer à ce niveau un transfert en volume ce qui améliore la qualité du transfert et diminue le bruit. Toutefois, cette zone peut aussi être réalisée directement sur le substrat de type P. Dans tous les cas, les diodes $D_B$ et D' sont réalisées par des diffusions de type N+.

Le fonctionnement d'un étage du système de multiplexage et de lecture est le suivant:

Pendant le temps d'intégration, les charges $Q_S$ détectées par le détecteur photosensible $D_{32}$ viennent se stocker sur la diode D'. Le potentiel $Ø_P$ de la grille $G_P$ est à un niveau bas ce qui empêche le transfert des charges $Q_S$ vers le registre R. D'autre part, en cas d'éblouissement, à savoir si la charge $Q_S$ est trop importante, les charges en excès sont évacuées vers la diode $D_B$ par dessus la barrière de potentiel formée sous la grille $G_B$ portée à une tension fixe $V_B$ choisie de telle sorte que le potentiel de canal formé sous la grille $G_B$ soit supérieur au potentiel de canal formé sous la grille $G_P$. Pendant ce temps d'intégration, un fond de charge $Q_O$ est injecté en série dans tous les étages du registre R comme mentionné ci-dessus. Une fois l'intégration réalisée, le potentiel $Ø_O$ de la grille $G_P$ est porté à un niveau haut alors que le potentiel de commande $Ø_1$ du registre R se trouve au niveau bas. Ainsi le fond de charge $Q_O$ est transféré vers la diode D' et sur la grille $G_P$ où il vient s'ajouter à la charge signal $Q_S$, comme représenté à la figure 5c. Ensuite, comme représenté à la figure 5d, l'ensemble des charges $Q_S + Q_O$ est transféré vers l'étage d'entrée du registre à décalage à transfert de charge lorsque $Ø_1$ passe à un niveau haut. Puis, comme représenté en tiretés sur la figure 5d, le potentiel $Ø_P$ de la grille $G_P$ est ramené à un niveau bas et le cycle d'intégration suivant peut recommencer. Comme on le voit clairement sur les figures 5b à 5d, le niveau de référence de la diode D' est donné par le niveau haut du potentiel sous la grille $G_P$.

L'utilisation d'un fond de charge permet d'améliorer le transfert du signal vers le registre à transfert de charge. Elle évite les phénomènes de trainage ou de rémanence du signal, et permet de contrôler le niveau et la résolution du signal de sortie.

D'autre part, le dispositif anti-éblouissement destiné à éviter la répartition de l'excès de charge d'un détecteur suréclairé vers les détecteurs voisins ou vers le système de multiplexage et de lecture permet également d'éviter l'introduction dans le registre à décalage d'une quantité de charge dépassant la capacité de chacun de ses étages.

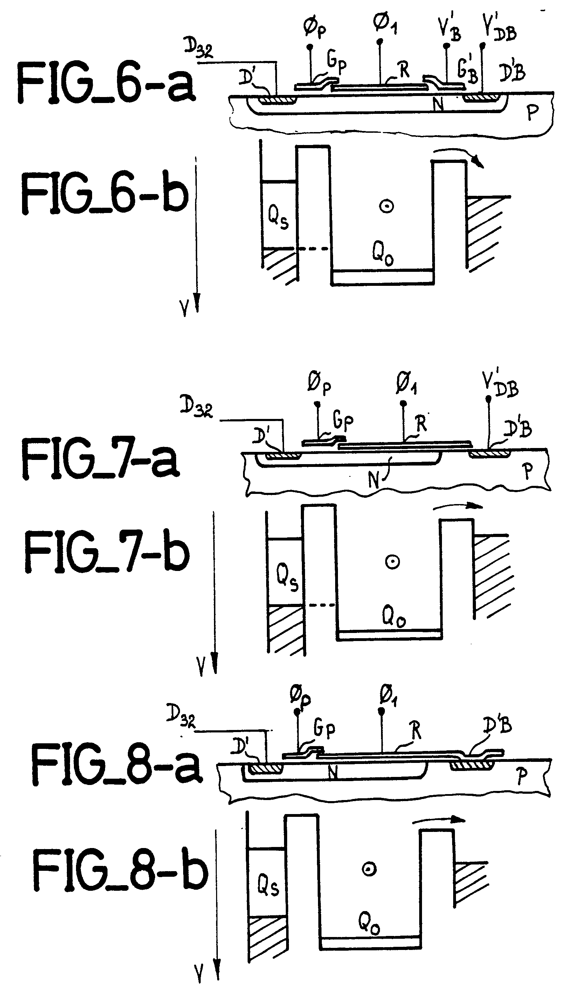

Cette dernière fonction peut également être réalisée à l'aide d'un transistor MOS d'anti-éblouissement directement associé à chaque étage du registre à décalage. Des exemples de configuration de ce transistor MOS associé à chaque étage du registre sont représentés sur les figures 6a, 6b, 7a, 7b et 8a, 8b.

Sur les figures 6a et 6b, le transistor MOS d'anti-éblouissement est réalisé par la diode $D'_B$ portée à un potentiel de polarisation $V'_{DB}$, la grille $G'_B$ portée à une tension fixe $V'_B$ et par l'étage d'entrée du registre R, ces différents éléments étant réalisés sur la zone N. Ainsi lorsque la charge signal $Q_S$ transférée est trop importante par rapport à la capacité de chaque étage du registre R, les charge en excès sont évacuées par dessus la barrière de potentiel formée sous la grille $G'_B$.

Sur les figures 7a et 7b, la zone N ne s'étend que sous une partie des étages du registre CCD et le transistor MOS d'anti-éblouissement est constitué par la diode $D'_B$ réalisée par une diffusion de type N+ dans le substrat P et portée à un potentiel de polarisation $V'_{DB}$, par la partie de grille du registre R recouvrant le substrat P et par la partie de grille du registre R recouvrant la zone N. Dans ce cas, les charges en excès sont évacuées par dessus la barrière de potentiel formée sous la partie de grille du registre R recouvrant le substrat P et due à la différence de dopage entre la zone N et le substrat P.

Sur les figures 8a et 8b, on a représenté une variante de réalisation des figures 7a et 7b dans laquelle la diode $D'_B$ n'est pas portée à un potentiel de polarisation $V'_{DB}$ mais polarisée par le potentiel de commande $\emptyset_1$ du registre à décalage.

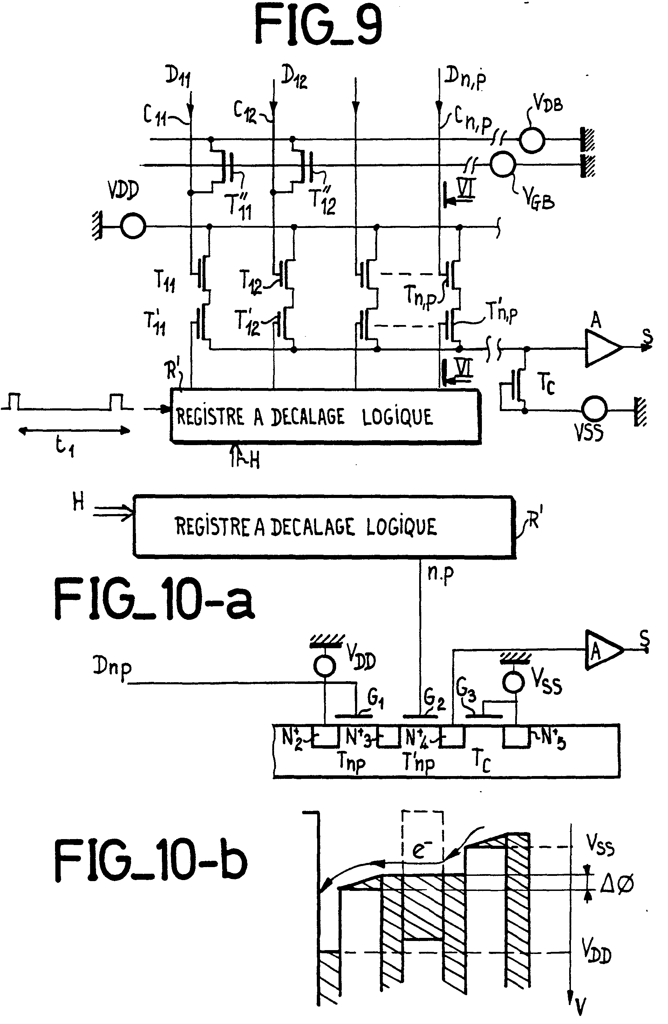

Les figures 9 et 10 représentent un autre mode de réalisation du système de multipiexage et de lecture. Dans ce mode de réalisation, les charges intégrées par les détecteurs photosensibles sont lues directement en tension et multiplexées en utilisant un registre à décalage logique R'.

Le système de conversion représenté comporte des moyens de lecture en tension constitués par des transistors MOS $T_{11}$, $T_{12}$ ... $T_{np}$ ... $T_{NP}$ montés en étage suiveur. La grille $G_1$ de chaque transistor MOS $T_{np}$ est reliée par une connexion $C_{11}$, $C_{12}$, ... $C_{np}$ ...., à un détecteur photosensible $D_{11}$, $D_{12}$, ... $D_{np}$ ... réalisé par une diffusion de type N. Le drain des transistors MOS $T_{np}$ réalisé par la diffusion de type N référencée $N_2$+ sur la figure 10a est relié à une tension de polarisation $V_{DD}$.

D'autre part, la source des transistors MOS $T_{np}$ référencée $N_3$+ sur la figure 10a est connectée par l'intermédiaire d'un transistor MOS $T'_{np}$ jouant le rôle d'interrupteur à une charge TC. On utilise, dans le mode de réalisation représenté, une charge unique pour tous les étages suiveurs ce qui permet de limiter la puissance. Toutefois, on pourrait aussi utiliser une charge par étage suiveur. La charge TC est constituée par un transistor MOS à dépletion dont la grille $G_3$ est connectée à la source réalisée par la diffusion de type N référencée $N_5$+ sur la figure 10a, cette source etant polarisée par une tension continue $V_{SS}$. Toutefois, la charge pourrait être réalisée par d'autres types de sources de courant ou par une résistance.

De plus, chaque grille $G_2$ des transistors MOS interrupteurs $T'_{np}$ est reliée à une des sorties d'un registre à décalage logique R' à entrée série et sorties parallèles. Ce registre à décalage R' permet d'adresser et de rendre passant un des transistors MOS $T'_{np}$ les autres transistors étant bloqués. Ainsi on effectue un muitipiexage des différents étages suiveurs.

Comme pour le mode de réalisation des figures 3 à 5, un dispositif anti-éblouissement peut être prévu au niveau de chaque détecteur. Ce dispositif anti-éblouissement est constitué dans le mode de réalisation de la figure 9 par un transistor MOS $T''_{11}$, $T''_{12}$ dont le drain est connecté à un potentiel de polarisation $V_{DB}$, la grille au potentiel $V_{GB}$ et la source à la connexion correspondante $C_{11}$, $C_{12}$, ...

On expliquera maintenant le fonctionnement du système décrit ci-dessus avec référence à la figure 10b qui représente les potentiels de surface dans le substrat lors de la lecture d'un détecteur $D_{np}$.

Les charges créées dans le détecteur $D_{np}$ par le rayonnement sont stockées dans la capacité de la jonction formée par cette diffusion avec le substrat.

La lecture des charges stockées dans une desdites capacités est réalisée lorsque la sortie n.p correspondante du registre à décalage R' est au niveau logique 1 de sorte que la grille du transistor MOS $T'_{np}$ reçoive une tension élevée rendant passant ledit transistor, toutes les grilles des autres transistors MOS jouant le rôle d'interrupteur recevant un niveau logique "O" bloquant lesdits transistors. Dans ce cas, le transistor MOS $T'_n$ se comporte comme une résistance, le transistor TC à savoir la charge, se trouve connecté au transistor suiveur $T_{np}$ et on obtient donc un étage suiveur classique, la tension de polarisation $V_{DD}$ étant choisie très supérieure à la tension de polarisation $V_{SS}$ comme représenté sur la figure 10b.

Le détecteur $D_{np}$ étant connecté à la grille $G_1$ du transistor MOS $T_{np}$ on obtient au niveau de cette grille un potentiel représentatif de la quantité de charge intégrée dans le détecteur $D_{np}$. En effet, comme le détecteur $D_{np}$ est relié à la grille $G_1$, le potentiel sous cette grille s'aligne, en prenant en compte la différence de potentiel due à l'isolant, sur le potentiel au niveau du détecteur.

De plus, comme dans le cas de la lecture, le transistor $T'_{np}$ est équivalent à une résistance, le potentiel au niveau de ia diffusion $N_4$+ s'aligne sur le potentiel au niveau de la diffusion $N_3$+. Or le potentiel au niveau de la diffusion $N_3$+ est fonction du potentiel sous la grille $G_1$, car dans un étage suiveur la différence de potentiel est une constante. On obtient donc au niveau de la diffusion $N_4$+ une tension représentative des charges stockées dans ie détecteur $D_{np}$. Cette tension est envoyée à travers l'amplificateur A sur la borne de sortie S de la barrette multilinéaire.

D'autre part, on a représenté en pointillés sur la figure 10b le potentiel sous la grille $G_2$ lorsqu'un niveau logique "O" est appliqué sur cette grille. On voit que, dans ce cas, le courant symbolisé par la flèche e- ne peut pas s'écouler du transistor MOS de charge TC vers le transistor MOS suiveur $T_{np}$.

Après avoir lu l'information sur l'entrée n.p, on décale le niveau logique "1" du registre à décalage R' d'un étage sous l'action de l'horloge H et on réalise ensuite la lecture de l'entrée n.p + 1. Si le registre R' est un registre série, un niveau logique "1" est entré dans le registre au début de chaque cycle d'intégration. Toutefois on pourrait utiliser un registre à décalage logique bouclé.

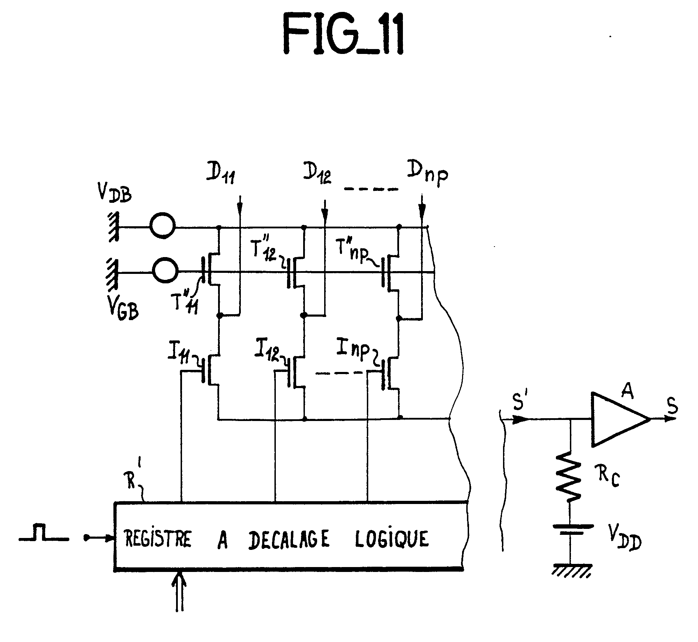

Sur la figure 11, on a représenté un troisième mode de réalisation du système de multiplexage et de lecture. Dans ce mode de réalisation, les charges intégrées par les détecteurs photosensibles $D_{11}$, $D_{12}$,...$D_{np}$ sont lues par l'intermédiaire du courant qui traverse la résistance $R_c$ située en sortie.

Le système de démultiplexage et de lecture représenté comporte des transistors MOS $I_{11}$, $I_{12}$,... $I_{np}$, ... montés en interrupteurs, dont les drains sont reliés à une tension continue $V_{DD}$ par l'intermédiaire d'une résistance de charge $R_C$. Les sources des transistors MOS $I_{11}$, $I_{12}$, ... $I_{np}$, ... sont reliées par l'intermédiaire de connexions $C_{11}$, $C_{12}$, ... $C_{np}$, ... aux détecteurs $D_{11}$, $D_{12}$, ... $D_{np}$, ... Ces détecteurs sont également reliés, comme dans le mode de réalisation de la figure 9, à des transistors $T''_{11}$, $T''_{12}$,... $T''_{np}$, ... d'anti-éblouissement.

D'autre part, les grilles des transistors MOS $I_{11}$, $I_{12}$, ... $I_{np}$, ... sont reliées aux sorties d'un registre à décalage logique R' à entrée série et sorties parallèles identique au registre R' du mode de réalisation de la figure 9.

Le fonctionnement du système décrit ci-dessus est le suivant.

Les charges créées dans le détecteur $D_{np}$ par le rayonnement sont stockées dans la capacité formée par la jonction $D_{np}$ avec le substrat. La lecture des charges stockées dans cette capacité est réalisée lorsque le transistor interrupteur $I_{np}$ correspondant est passant, à savoir lorsqu'un niveau logique "1" est appliqué sur sa grille. Cette lecture est obtenue par la reproduction en sortie à l'aide de l'amplificateur A de la tension produite par le courant des charges stockées à travers la résistance $R_C$ reliée à la tension continue $V_{DD}$.

Le déplacement de ces charges une fois achevé, la tension sur le détecteur $D_{np}$ reprend une valeur définie par la tension continue $V_{DD}$. Le détecteur est ensuite isolé par l'ouverture du transistor interrupteur $I_{np}$ en envoyant un niveau logique "0" sur sa grille.

Il est évident pour l'homme de l'art que les éléments A, R et $V_{DD}$ peuvent être réalisés extérieurement à la barrette multi-linéaire.

Sur les figures 1 à 11 on a représenté différents modes de réalisation d'une barrette multilinéaire à transfert de charge élémentaire dans lesquels les détecteurs sont lus individuellement. Comme mentionné dans l'introduction il est souhaitable dans certaines applications, en particulier dans les applications radiologiques, de pouvoir réunir plusieurs barrettes élémentaires pour obtenir une barrette multilinéaire à transfert de charge allongée. Dans les barrettes élémentaires décrites ci-dessus, on réalise une lecture individuelle des détecteurs, le traitement des signaux obtenus, en particulier la fonction TDI, étant reporté à l'extérieur du dispositif. De ce fait, il est possible de modifier la structure de la barrette élémentaire ou de réaliser un balayage qui ne soit pas perpendiculaire aux lignes de la zone photosensible, pour résoudre le problème mentionné ci-dessus, de manière à associer lors du traitement,des détecteurs situés sur des barrettes élémentaires différentes ce qui permet de réduire ou même d'annuler les défauts de raccordement d'images.

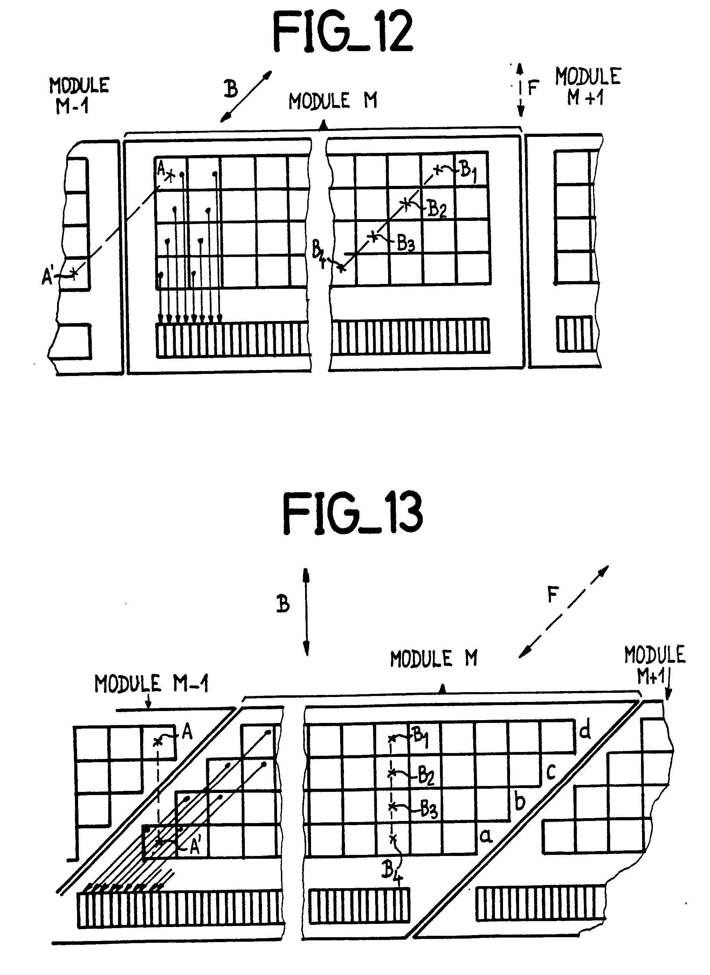

Ainsi, comme représenté sur la figure 12, les différentes barrettes élémentaires M-1, M et M+1 sont réalisées par des barrettes multilinéaires du type de celle décrite avec référence à la figure 2. Dans ce cas les différentes lignes de la zone photosensible sont alignées les unes avec les autres mais pour éviter les défauts de raccordement au niveau des extrémités de chaque barrette, le balayage a lieu en oblique selon la direction B. De ce fait, au niveau du traitement des détecteurs prévus aux extrémités, le détecteur référencé A' de la dernière ligne du la barrette M-1 est associé au détecteur référencé A de la première ligne de la barrette M.

Selon un autre mode de réalisation représenté à la figure 13, chaque ligne de détecteurs est décalée d'un détecteur par rapport aux lignes adjacentes. De ce fait, l'alignement des détecteurs manquant est réalisé selon la flèche oblique F en tiretés. Dans ce cas, le balayage B est réalisé perpendiculairement aux lignes photosensibles. Ainsi, au niveau des extrémités de chaque barrette, le détecteur référencé A de la barrette M-1 est traité avec le détecteur référencé A' de la barrette M. Il est évident pour l'homme de l'art que chaque ligne de détecteur peut aussi être décalée de plusieurs détecteurs par rapport aux lignes adjacentes.

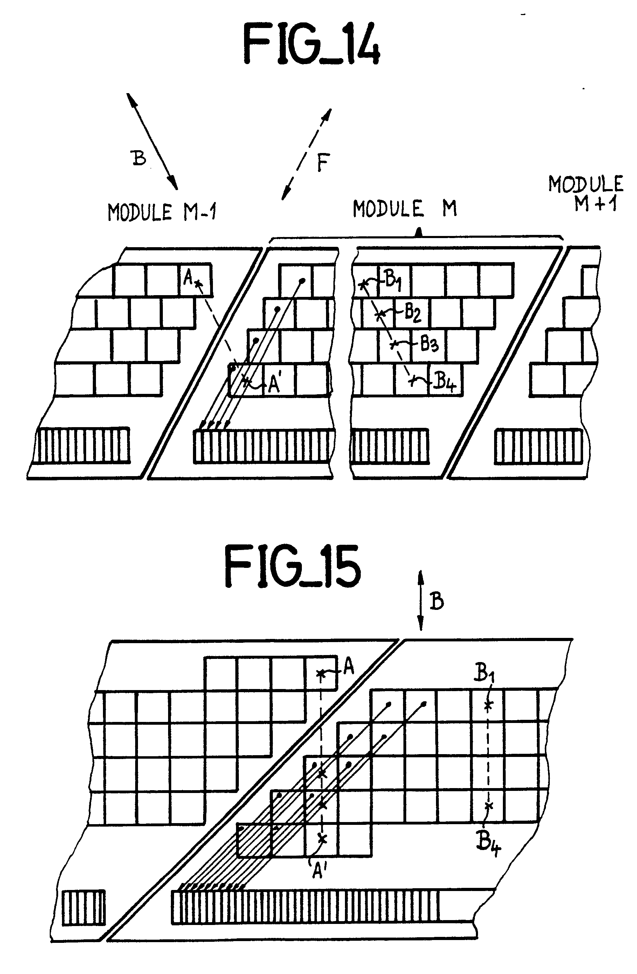

Selon encore un autre mode de réalisation représenté à la figure 14, chaque ligne de détecteurs d'une barrette élémentaire est décalée d'un demi-détecteur par rapport aux lignes adjacentes. Dans ce cas, la direction des détecteurs manquant à savoir le bord de la barrette est représentée par la flèche F en tiretés et la direction du balayage B est oblique, le détecteur référencé A sur la barrette M-1 étant traité avec le détecteur référencé A' sur la barrette M. Il est évident pour l'homme de l'art que chaque ligne de détecteurs peut aussi être décalée d'une partie de détecteur par rapport aux lignes adjacentes.

Toutefois, on remarque que dans les configurations des figures 12 à 14, le nombre de détecteurs à composer pour réaliser l'opération TDI reste plus faible au niveau des extrémités des barrettes qu'ailleurs. En effet, comme représenté sur ces différentes figures comportant à titre illustratif uniquement quatre lignes, aux extrémités de la barrette on associe deux ou trois détecteurs tandis qu'au milieu de la barrette on associe quatre détecteurs $B_1$, $B_2$, $B_3$, $B_4$.

Pour remédier à cet inconvénient, on peut adopter la configuration représentée à la figure 15. Comme représenté sur cette figure, on rajoute localement au niveau des deux extrémités latérales d'une barrette élémentaire, une ou deux lignes supplémentaires de N détecteurs, N correspondant au nombre de lignes de la barrette.

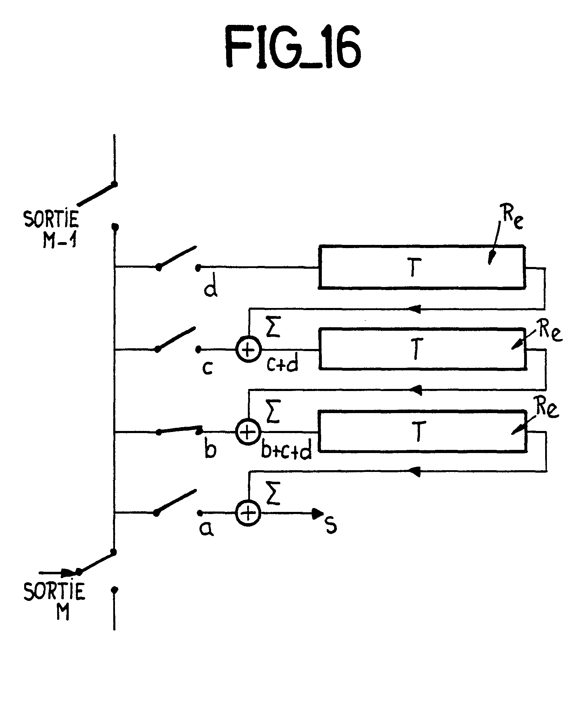

On expliquera maintenant, en se référant aux figures 13 et 16, un principe pouvant être utilisé pour la réalisation de la fonction TDI en dehors des barrettes élémentaires M-1, M, M+1.

Si l'on considère par exemple la disposition de la figure 13 dans laquelle les éléments des quatre lignes a, b, c, d sont repérés par le numéro de leur position le long de la ligne:

$a_i$, $b_i$, $c_i$, $d_i$, les éléments à composer ayant le même indice, la séquence à la sortie du registre à décalage sera la suivante:

$a_1$, $b_2$, $c_3$, $d_4$, $a_2$, $b_3$, $c_4$, $d_5$, $a_3$, $b_4$, $c_5$, $d_6$, $a_4$, ....

Par exemple, le cumul des signaux des éléments de la quatrième colonne sera obtenu en effectuant l'opération:

$$V_4 = d_4 (3T) + c_4 (2T) + b_4 (T) + a_4$$

dans laquelle T est le temps de déplacement de l'image d'une ligne à la suivante.

Les retards et la somme ci-dessus peuvent être obtenus par voie analogique ou numérique selon le principe représenté à la figure 16.

Sur cette figure, les éléments des différentes lignes à composer sont symbolisés par des contacteurs d, c, b, a. Le signal de l'élément d après être passé dans un registre Re le retardant de T est envoyé sur un sommateur Σ qui reçoit sur son autre entrée le signal de l'élément c. La sortie c + d après être passée sur un registre Re lui donnant un retard T est envoyée sur un sommateur Σ dont l'autre entrée reçoit le signal de l'élément b. La somme b + c d après avoir été retardée d'un temps T est envoyée sur un sommateur Σ dont l'autre entrée reçoit le signal de l'élément a et la sortie S donne le signal composé.

D'autre part, la sortie d'une barrette élémentaire peut être connectée à la barrette suivante par un commutateur de manière à composer des éléments se trouvant sur des barrettes différentes.

Il est évident que la figure 16 ne représente qu'un principe de réalisation de la fonction TDI.

Les modes de réalisation décrits ci-dessus n'ont été donnés qu'à titre illustratif et peuvent être modifiés de nombreuses manières. En particulier, dans le cas de la figure 1, les registres à décalage à transfert de charge peuvent être positionnés de chaque côté de la zone photosensible ou bien latéralement ou même éventuellement repliés sur eux même.

D'autre part, on peut aussi concevoir une barrette multi-linéaire dans laquelle seul un certain nombre de détecteurs prévus aux extrémités de chaque ligne sont lus individuellement en utilisant une structure telle que décrite ci-dessus, la fonction TDI étant intégrée à la barrette pour les détecteurs centraux.

**Revendications**

1. Capteur d'images permettant de réaliser la fonction d'intégration avec report de charges (TDI) comprenant au moins deux barrettes multilinéaires à transfert de charge élémentaires constituées chacune par N lignes de P détecteurs photosensibles ($D_{11}...D_{1P}$, $D_{21}...D_{2P}$, ... $D_{N1}$ ... $D_{NP}$) mises bout à bout pour augmenter la longueur de la ligne de photodétecteurs, les N lignes étant balayées séquentiellement par le rayonnement à détecteur lors de l'analyse et les signaux obtenus en sortie de la barrette étant transmis via un système de multiplexage et lecture (DIC, $R_1$, $L_1$;... DIC, $R_N$, $L_N$; DIC, R, L; $T_{np}$, $T'_{np}$, R') à un dispositif de traitement extérieur à la barrette, chaque détecteur ($D_{np}$) étant relié directement par une connexion ($C_{np}$) audit système de multiplexage et lecture et la direction de balayage (B) formant un angle non nul par rapport à l'alignement (F) des détecteurs de même rang des différentes lignes.

2. Capteur selon la revendication 1, caractérisé en ce que chaque ligne de détecteurs (a, b, c, d; Fig. 13) est décalée d'un ou de plusieurs détecteurs par rapport aux lignes adjacentes, la direction du balayage (B) étant perpendiculaire aux lignes.

3. Capteur selon la revendication 1, caractérisé en ce que chaque ligne de détecteurs est décalée d'un demi ou d'une partie de détecteur par rapport aux lignes adjacentes.

4. Capteur selon la revendication 1, caractérisé en ce que les lignes de détecteurs sont alignées.

5. Capteur selon l'une quelconque des revendications 1 à 4, caractérisé en ce que la barrette comporte au niveau des deux extrémités latérales, au moins une ligne supplémentaire de N détecteurs.

6. Capteur selon la revendication 1, caractérisé en ce que le système de multiplexage et de lecture comporte au moins un dispositif de multiplexage à entrées parallèles et sortie série ($R_1$ à $R_N$, R, R' et $T'_{np}$).

7. Capteur selon l'une quelconque des revendications 1 à 5, caractérisé en ce que le système de multiplexage et de lecture est constitué par $n_0$ registres à décalage à transfert de charge à entrées parallèles et sortie série comportant $p_0$ étages, $n_0$ étant un nombre entier choisi de telle sorte que $n_0$ = N x pas minimum des registres/pas des détecteurs et $p_0$ étant choisi de telle sorte que $p_0$ x $n_0$ = N x P chaque connexion ($C_{np}$) issue d'un détecteur ($D_{np}$) étant reliée à une entrée d'un des registres à décalage par l'intermédiaire d'un dispositif d'injection de charge (DIC) et les sorties des registres étant reliées chacune au dispositif de traitement extérieur par l'intermédiaire d'un étage de lecture charge-tension (L, $L_1$ à $L_{no}$).

8. Capteur selon la revendication 7, caractérisé en ce que, n égalant 1, le système de multiplexage comporte un registre (R) à décalage à transfert de charge à N x P étages, les connexions entre chaque détecteur et l'entrée correspondante du registre étant réalisées de sorte que les détecteurs de même rang ($D_{1P}$, $D_{2P}$...$D_{NP}$) soient connectés à des entrées contigües.

9. Capteur selon la revendication 7, caractérisé en ce que, n égalant N, le système de multiplexage comporte N registres ($R_1$ à $R_N$) à décalage à transfert de charge à P étages, chaque ligne de photo-détecteurs étant connectée à un registre à décalage.

10. Capteur selon l'une quelconque des revendications 7 à 9, caractérisé en ce que chaque étage du registre à décalage est associé à un dispositif anti-éblouissement ($D'_B$, $G'_B$).

11. Capteur selon l'une quelconque des revendications 7 à 10, caractérisé en ce que chaque dispositif d'injection de charge (DIC) est constitué par:
- une diode (D') d'injection des charges reliée à un détecteur par une connexion, et
- une grille d'injection ($G_P$) qui contrôle le passage des charges vers l'entrée d'un étage du registre à décalage à transfert de charge.

12. Capteur selon la revendication 11, caractérisé en ce que le dispositif d'injection de charge est associé à un dispositif anti-éblouissement.

13. Capteur selon la revendication 12, caractérisé en ce que le dispositif anti-éblouissement est constitué par une diode ($D_B$) séparée de la diode d'injection (D') par une grille écran ($G_B$) portée à une tension fixe ($V_B$).

14. Capteur selon l'une quelconque des revendications 7 à 13, caractérisé en ce qu'il comporte des moyens pour superposer aux charges-signal ($Q_S$) provenant de chaque détecteur un fond de charge ($Q_O$) permettant de contrôler ou d'améliorer le niveau et/ou la résolution du signal de sortie.

15. Capteur selon la revendication 14, caractérisé en ce que le moyen pour superposer aux charges-signal un fond de charge est constitue par un étage d'injection de charge (De, $G'_1$, $G'_2$) injectant en série le fond de charge dans le ou les registres à transfert de charge.

16. Capteur selon l'une quelconque des revendications 1 à 5, caractérisé en ce que le système de multiplexage et de lecture est constitué par des moyens de lecture en tension ($T_{np}$, TC) reliés chacun à une connexion issue d'un détecteur et par au moins un moyen d'adressage (R') pour adresser sequentiellement un des moyens de lecture de manière à réaliser successivement la lecture de chaque détecteur.

17. Capteur seion la revendication 16, caractérisé en ce que le moyen de lecture en tension est constitué par un étage suiveur ($T_{np}$) dont l'entrée est reliée par une connexion ($C_{np}$) à un détecteur ($D_{np}$).

18. Capteur selon l'une quelconque des revendications 16 et 17, caractérisé en ce que le moyen d'adressage (R') est constitué par un registre à décalage logique à sorties parallèles, dont chaque sortie est reliée par l'intermédiaire d'un interrupteur ($T'_{np}$) à un moyen de lecture pour débloquer cycliquement le moyen de lecture lors d'un niveau logique "1".

19. Capteur selon la revendication 16, caractérisé en ce que chaque moyen de lecture en tension est constitué par un transistor MOS ($I_{np}$) dont la source est connectée au détecteur correspondant ($D_{np}$), la grille au moyen d'adressage constitué par un registre à décalage logique (R') et le drain à une résistance de charge ($R_C$) reliée à une tension continue ($V_{DD}$).

20. Capteur selon l'une quelconque des revendications 16 à 19, caractérisé en ce qu'un dispositif anti-éblouissement ($T'_{np}$) est associé à chaque détecteur.

21. Capteur selon la revendication 1, caractérisé en ce que, lorsque chaque ligne de la barrette reçoit successivement le rayonnement à détecter, le dispositif de traitement extérieur est un dispositif asurant la sommation en phase des informations collectées sur les détecteurs occupant une même position par rapport à la direction de balayage sur les différentes lignes.

22. Capteur selon la revendication 21, caractérisé en ce que le dispositif assurant la sommation en phase des informations collectees sur les détecteurs est un dispositif analogique ou numérique.

**Patentansprüche**

1. Bildaufnehmer, der die Integrationsfunktion mit Ladungsweitergabe (time delay integration) durchzuführen vermag und mindestens zwei multilineare elementare Ladungstransferblöcke enthält, die je von N Zeilen mit je P lichtempfindlichen und eng nebeneinander liegenden Detektoren ($D_{11}$...$D_{1P}$, $D_{21}$...$D_{2P}$, $D_{N1}$...$D_{NP}$) gebildet werden, um die Länge der Zeile aus Photodetektoren zu vergrößern, wobei die N Zeilen nacheinander von der aufzunehmenden Strahlung während der Analyse überstrichen werden und die erhaltenen Ausgangssignale des Blocks über ein Multiplexier- und Lesesystem (DIC, $R_1$, $L_1$; ...DIC, $R_N$, $L_N$; DIC, R, L; $T_{np}$, $T'_{np}$, R') an eine außerhalb des Blocks befindliche Verarbeitungsvorrichtung übertragen werden, wobei jeder Detektor ($D_{np}$) unmittelbar über eine Verbindung ($C_{np}$) an das Multiplexier- und Lesesystem angeschlossen ist und die Überstreichrichtung (B) einen von Null verschiedenen Winkel mit der Fluchtrichtung (F) der Detektoren gleichen Rangs in den verschiedenen Zeilen einschließt.

2. Aufnehmer nach Anspruch 1, dadurch gekennzeichnet, daß jede Zeile von Detektoren (a, b, c, d; Fig. 13) um einen oder mehrere Detektoren bezüglich der benachbarten Zeile verschoben ist, wobei die Überstreichrichtung (B) senkrecht zur Zeilenrichtung verläuft.

3. Aufnehmer nach Anspruch 1, dadurch gekennzeichnet, daß jede Zeile von Detektoren um einen halben Detektor oder einen Teil eines Detektors bezüglich der benachbarten Zeile verschoben ist.

4. Aufnehmer nach Anspruch 1, dadurch gekennzeichnet, daß die Zeilen von Detektoren fluchten.

5. Aufnehmer nach einem beliebigen der Ansprüche 1 bis 4, dadurch gekennzeichnet, daß der Block in Höhe der beiden seitlichen Enden mindestens eine zusätzliche Zeile von N Detektoren aufweist.

6. Aufnehmer nach Anspruch 1, dadurch gekennzeichnet, daß das Multiplexier- und Lesesystem mindestens eine Multiplexiereinrichtung mit parallelen Eingängen und Reihenausgang ($R_1$ bis $R_N$, R, R' und $T'_{np}$) aufweist.

7. Aufnehmer nach einem beliebigen der Ansprüche 1 bis 5, dadurch gekennzeichnet, daß das Multiplexier- und Lesesystem aus $n_o$ Ladungstransferschieberegistern mit parallelen Eingängen und eimem Reihenausgang sowie mit $p_o$ Stufen besteht, wobei $n_o$ eine ganze Zahl ist, die so gewählt ist, daß $n_o = $ N.Minimalteilung der Register/Teilung der Detektoren ist und $p_o$ so gewählt ist, daß $p_o.n_o =$ N.P, und wobei jede Verbindung ($C_{np}$) die von einem Detektor ($D_{np}$) ausgeht, an einen Eingang eines der Schieberegister über eine Ladungsinjektionsvorrichtung (DIC) angeschlossen ist und die Ausgänge der Register je über eine Ladungs-Spannungs-Lesestufe (L, $L_1$ bis $L_{no}$) an die äußere Verarbeitungsvorrichtung angeschlossen ist.

8. Aufnehmer nach Anspruch 7, dadurch gekennzeichnet, daß für n = 1 das Multiplexiersystem ein Ladungstransferschieberegister (R) mit N.P Stufen aufweist, wobei die Verbindungen zwischen jedem Detektor und dem entsprechenden Registereingang so durchgeführt sind, daß die Detektoren gleichen Rangs ($D_{1P}$, $D_{2P}$...$D_{NP}$) an benachbarte Eingänge angeschlossen sind.

9. Aufnehmer nach Anspruch 7, dadurch gekennzeichnet, daß für n = N das Multiplexiersystem N Ladungstransferschieberegister ($R_1$ bis $R_N$) mit P Stufen aufweist, wobei jede Photodetektorzeile mit einem Schieberegister verbunden ist.

10. Aufnehmer nach einem beliebigen der Ansprüche 7 bis 9, dadurch gekennzeichnet, daß jede Stufe des Schieberegisters einer Antiblendvorrichtung ($D'_B$, $G'_B$) zugeordnet ist.

11. Aufnehmer nach einem beliebigen der Ansprüche 7 bis 10, dadurch gekenzeichnet, daß jede Ladungsinjektionsvorrichtung (DIC) aus
- einer Ladungsinjektionsdiode (D'), die an einen Detektor über eine Verbindung angeschlossen ist, und
- ein Injektionsgitter ($G_P$) aufweist, das den Durchlaß der Ladungen an den Eingang einer Ladungstransferschieberegisterstufe kontrolliert.

12. Aufnehmer nach Anspruch 11, dadurch gekennzeichnet, daß die Ladungsinjektionsvorrichtung einer Antiblendvorrichtung zugeordnet ist.

13. Aufnehmer nach Anspruch 12, dadurch gekennzeichnet, daß die Antiblendvorrichtung von einer Diode ($D_B$) gebildet wird, die durch ein auf eine feste Spannung ($V_B$) gebrachtes Schirmgitter ($G_B$) von der Injektionsdiode (D') separiert ist.

14. Aufnehmer nach einem beliebigen der Ansprüche 7 bis 13, dadurch gekennzeichnet, daß er Mittel enthält, um den von jedem Detektor kommenden Signalladungen ($Q_S$) eine Basisladung ($Q_O$) zu überlagern, die es erlaubt, dem Pegel und/oder die Auflösung des Ausgangssignals zu steuern oder zu verbessern.

15. Aufnehmer nach Anspruch 14, dadurch gekennzeichnet, daß die Mittel, um den Signalladungen eine Basisladung zu überlagern, von einer Ladungsinjektionsstufe (De, $G'_1$, $G'_2$) gebildet werden, die in Reihe die Basisladung in das oder die Ladungstransferschieberegister einspeist.

16. Aufnehmer nach einem beliebigen der Ansprüche 1 bis 5, dadurch gekennzeichnet, daß das Multiplexier- und Lesesystem von Spannungslesemitteln ($T_n$, TC), die je an eine von einem Detektor kommende Verbindung angeschlossen sind, und von mindestens einem Adressiermittel (R') gebildet wird, um nacheinander eines der Lesemittel zu adressieren, so daß nacheinander jeder Detektor abgefragt wird.

17. Aufnehmer nach Anspruch 16, dadurch gekennzeichnet, daß die Spannungslesemittel von einer Folgestufe ($T_{np}$) gebildet werden, deren Eingang über eine Verbindung ($C_{np}$) an einen Detektor ($D_{np}$) angeschlossen ist.

18. Aufnehmer nach einem beliebigen der Ansprüche 16 und 17, dadurch gekennzeichnet, daß das Adressiermittel (R') von einem logischen Schieberegister mit parallelen Ausgängen gebildet wird, von dem jeder Ausgang über einen Unterbrecher ($T'_{np}$) mit einem Lesemittel verbunden ist, um zyklisch das Lesemittel bei einem logischen Pegel "1" zu entsperren.

19. Aufnehmer nach Anspruch 16, dadurch gekennzeichnet, daß jedes Spannungslesemittel von einem MOS-Transistor ($I_{np}$) gebildet wird, dessen Sourceelektrode an den entsprechenden Detektor ($D_{np}$), dessen Gateelektrode an das von einem logischen Schieberegister (R') gebildete Adressiermittel und dessen Drainelektrode an einen Lastwiderstand ($R_C$) angeschlossen ist, der an eine Gleichspannung ($V_{DD}$) führt.

20. Aufnehmer nach einem beliebigen der Ansprüche 16 bis 19, dadurch gekennzeichnet, daß eine Antiblendvorrichtung ($T'_{np}$) jedem Detektor zugeordnet ist.

21. Aufnehmer nach Anspruch 1, dadurch gekennzeichnet, daß, wenn jede Zeile des Blocks nacheinander die aufzunehmende Strahlung empfängt, die äußere Verarbeitungsvorrichtung eine Vorrichtung ist, die die phasengerechte Summierung der auf den Detektoren, die eine gleiche Lage bezüglich der Überstreichrichtung auf den verschiedenen Zeilen einnehmen, gesammelten Informationen bewirkt.

22. Aufnehmer nach Anspruch 21, dadurch gekennzeichnet, daß die Vorrichtung, die die phasenmäßige Summierung der von den Detektoren gesammelten Informationen bewirkt, eine analoge oder digitale Vorrichtung ist.

**Claims**

1. An image pick-up system allowing the implementation of the time delay integration and comprising at least two multilinear elementary charge transfer bars each constituted by N lines of P photosensitive detectors ($D_{11}...D_{1P}$, $D_{21}...D_{2P}$, $D_{N1}...D_{NP}$) arranged end to end in order to increase the length of the photodetector line, the N lines being sequentially scanned by the radiation to be detected during the analysis, and the signals available at the output of the bar being transmitted via a multiplexing and reading system (DIC, $R_1$, $L_1$; ...DIC, $R_N$, $L_N$; DIC, R, L; $T_{np}$, $T'_{np}$, R') to a processing device external to the bar, each detector ($D_{np}$) being immediately connected by a link ($C_{np}$) to the multiplexing and reading system, and the scanning direction (B) being inclined by an angle which is not zero with respect to the alignment (F) of the detectors of equal rank in the different lines.

2. A pick-up system according to claim 1, characterized in that each line of detectors (a, b, c, d; Fig. 13) is shifted by one or several detectors with respect to the adjacent lines, the scanning direction (B) being perpendicular to the lines.

3. A pick-up system according to claim 1, characterized in that each line of detectors is shifted by half a detector or part of a detector with respect to the adjacent lines.

4. A pick-up system according to claim 1, characterized in that the lines of detectors are aligned.

5. A pick-up system according to any one of claims 1 to 4, characterized in that the bar comprises at both lateral ends at least one additional line of N detectors.

6. A pick-up system according to claim 1, characterized in that the multiplexing and reading system comprises at least one multiplexing device having parallel inputs and a series output ($R_1$ to $R_N$, R, R' and $T'_{np}$).

7. A pick-up system according to any one of claims 1 to 5, characterized in that the multiplexing and reading system consists of $n_0$ charge transfer shift registers having parallel inputs and a series output and comprising $p_0$ stages, $n_0$ being an integer number which is chosen such that $n_0 = N.$minimum pitch of the registers/pitch of the detectors and $p_0$ being selected such that $p_0.n_0 = N.P$, each link ($C_{np}$) issuing from a detector ($D_{np}$) being connected to an input of one of the shift registers via a charge injection device (DIC), and the outputs of the registers being each connected to the external processing device via a charge-voltage reading stage (L, $L_1$ to $L_{no}$).

8. A pick-up system according to claim 7, characterized in that with n = 1, the multiplexing system comprises a charge transfer shift register having NP stages, the links between each detector and the corresponding input of the register being realized in such a way that the detectors of the same rank ($D_{1P}$, $D_{2P}...D_{NP}$) are connected to adjacent inputs.

9. A pick-up system according to claim 7, characterized in that with n = N, the multiplexing system comprises N charge transfer shift registers ($R_1$ to $R_N$) having P stages, each photodetector line being connected to a shift register.

10. A pick-up system according to any one of claims 7 to 9, characterized in that each stage of the shift register is associated to an antiglaring device ($D'_B$, $G'_B$).

11. A pick-up system according to any one of claims 7 to 10, characterized in that each charge injection device (DIC) is constituted by:
- a charge injection diode (D') connected to a detector through a link, and
- an injection gate ($G_P$) controlling the passage of the charges applied to the input of a charge transfer shift register stage.

12. A pick-up system according to claim 11, characterized in that the charge injection device is associated to an antiglaring device.

13. A pick-up system according to claim 12, characterized in that the antiglaring device is constituted by a diode ($D_B$) separated from the injection, diode (D') by a screen grid ($G_B$) to which a fixed voltage ($V_B$) is applied.

14. A pick-up system according to any one of claims 7 to 13, characterized in that it comprises means for superposing a basic charge ($Q_O$) onto the signal charges ($Q_S$) issued by each detector in order to allow the level and/or the resolution of the output signal to be controlled or improved.

15. A pick-up system according to claim 14, characterized in that the means for superposing a basic charge to the signal charges is constituted by a charge injection stage (De, $G'_1$, $G'_2$) injecting the basic charge in series into the charge transfer register(s).

16. A pick-up system according to any one of claims 1 to 5, characterized in that the multiplexing and reading system is constituted by voltage reading means ($T_{np}$, TC), each connected via a link to a detector, and by at least one addressing means (R') in order to address sequentially one of the reading means and to realize successively the reading of each detector.

17. A pick-up system according to claim 16, characterized in that the voltage reading means is constituted by a follower stage ($T_{np}$) the input of which is connected by a link ($C_{np}$) to a detector ($D_{np}$).

18. A pick-up system according to any one of claims 16 and 17, characterized in that the addressing means (R') is constituted by a logic shift register having parallel outputs which are each connected via a switch ($T'_{np}$) to a reading means in order to cyclically enable the reading means when a logic level "1" is present.

19. A pick-up system according to claim 16, characterized in that each voltage reading means is constituted by a MOS transistor ($I_{np}$) the source of which is connected to the corresponding detector ($D_{np}$), the gate of which is connected to the addressing means constituted by a logic shift register (R') and the drain of which is connected to a charge resistor ($R_C$) connected to a DC voltage ($V_{DD}$).

20. A pick-up system according to any one of claims 16 to 19, characterized in that an antiglaring device ($T'_{np}$) is associated to each detector.

21. A pick-up system according to claim 1, characterized in that in the case each line of the bar receives successively the radiation to be detected, the external processing device is a device ensuring the in-phase addition of the informations collected on the detectors occupying the same position with respect to the scanning direction on the different lines.

22. A pick-up system according to claim 21, characterized in that the device ensuring the in-phase addition of the informations collected on the detectors is an analog device or a digital device.

# FIG_1

# FIG_2

EP 0 153 251 B1

# FIG_3

# FIG_4

3

FIG_5-a

$V_{DB}$ $V_B$ $\phi_P$ $\phi_1$

$D_{32}$ $G_B$ $D'$ $G_P$ $R$

$D_B$

N

P

FIG_5-b

0

$Q_\Delta$

$Q_0$

FIG_5-c

$Q_\Delta + Q_0$

FIG_5-d

$Q_\Delta + Q_0$

FIG_6-a

FIG_6-b

FIG_7-a

FIG_7-b

FIG_8-a

FIG_8-b

EP 0 153 251 B1

FIG_9

FIG_10-a

FIG_10-b

# FIG_11

# FIG_12

# FIG_13

# FIG_14

# FIG_15

# FIG_16